# EUROPEAN PATENT SPECIFICATION

(11) **EP 3 166 142 B1**
(45) Date of publication and mention of the grant of the patent: **21.07.2021**
(21) Application number: 15193403.1
(22) Date of filing: 06.11.2015
(51) Int. Cl.: H01L 23/49, H01L 21/60, H01L 23/495

(54) **BOND WIRE CONNECTION AND METHOD OF MANUFACTURING THE SAME**
BONDDRAHTVERBINDUNG UND VERFAHREN ZU DESSEN HERSTELLUNG
CONNEXION PAR FIL DE CONNEXION ET MÉTHODE DE SA PRODUCTION

(43) Date of publication of application: 10.05.2017
(73) Proprietor: NXP B.V., 5656 AG Eindhoven (NL)
(72) Inventor: Tanwongwan, Wiwat, Redhill, Surrey RH1 1SH (GB); Suwannakha, Piyarat, Redhill, Surrey RH1 1SH (GB); Suwankasab, Chanon, Redhill, Surrey RH1 1SH (GB)
(74) Representative: Lee, Candice Jane

(56) References cited:
- US-A1- 2005 173 791
- US-A1- 2010 176 500
- US-B1- 6 176 416

## Description

### Field

The present disclosure relates to wire bonding in integrated circuit packages and in particular, but not exclusively to, wedge bonding of bond wires between a die and a lead.

### Background

An integrated circuit package may be formed by encapsulating a die and portion of a lead frame using a compound such as an epoxy mold compound. Before encapsulation, the die may be coupled to leads of the lead frame via one or more bond wires forming a loop between the die and the leads. The bond wires can be bonded to the lead using wire bonding. One method of wire bonding is wedge bonding. In wedge bonding, the bond wire may be applied to the lead using ultrasonic.
The integrated circuit package may be tested to determine whether it adheres to minimum standards. A subset of these tests may include stress tests such as a life-time test, which may cause or exacerbate cracks in the wedge bonds. In some cases the cracks may be caused by delamination of wedge bond which may be a product of the different thermal properties of the different material in and around the wedge bond. Wedge bond cracks may affect the operation of the integrated circuit in some applications. Additionally some packages may have to have minimum reliability to meet customer requirements.

US2005/0173791 A1 provides a wire bonding method and a semiconductor package. A lead frame comprises a plurality of leads, which are arranged outside of and around a die pad on which a chip is mounted. A plurality of wires connects the leads to the chip. The wires are designed to avoid lateral deflection during an encapsulation phase. Lateral deflection occurs when resin flows laterally into a mold, into which the chip and lead frame have been placed. If the lateral deflection or *'wire sweep'* is too great, then adjacent wires come into contact and provide a short circuit. US2005/0173791 recognises that higher, longer wires are most prone to lateral deflection. The proposed wires of US2005/0173791 pass directly from a junction on a lead to a point where an upward bend is provided close to the edge of the chip. The portion of the wire between the junction at the lead and the upward bend lies below an active surface of the chip. This lower height portion of the wire is less prone to lateral deflection subsequently, when resin flows laterally into a mold in which the chip and lead frame are undergoing encapsulation. The wires with the lower height portion may be arranged alternately with conventional wires, around a chip. This alternate arrangement means that, if a wire is deflected laterally, it is less likely to contact the immediately adjacent wire.

### Summary

According to a first aspect, there is provided an integrated circuit package comprising: a die; a lead; and a bond wire comprising a first end coupled to the die and a second end coupled to the lead via a bond; the bond wire further comprising: a first portion between a first bend in the bond wire and the bond and forming a first angle with respect to the lead; a second portion forming a second angle with respect to the lead; wherein the first bend is immediately between the first and second portions and is configured to reduce the angle of the bond wire with respect to the lead from the second angle to the first angle. The first bend is in the vicinity of an edge of the lead and the first bend is displaced away from an edge of the lead, so that the first bend does not overlie the lead and the majority of the length of the first portion lies above the lead.

The first angle may be equal to or less than 10°. The bond wire may further comprise a third portion coupled between the second portion and the die. The two or more portions of the bond wire may be integral. The first bend may be formed by bending the bond wire in a direction opposite to the direction in which the lead lies relative to the bond wire. The bond wire may comprise at least one further bend between the first end of the bond wire and the first bend, the further bend configured to form at least part of a loop between the first end and the first bend. The bond may be one of a wedge bond and a stitch bond.

According to a second aspect, there is provided a method for coupling an integrated circuit die to a lead comprising: coupling a first end of a bond wire to an integrated circuit die; providing a first bend in the bond wire immediately between a first portion of the bond wire and a second portion of the bond wire; coupling a second end of the bond wire to a lead using a bond; wherein: the first portion of the bond wire is between the first bend and the bond and forms a first angle with respect to the lead; the second portion forms a second angle with respect to the lead; and the first bend is configured to reduce the angle of the bond wire with respect to the lead from the second angle to the first angle. The first bend (252) is in the vicinity of an edge of the lead (202) and the first bend is displaced away from an edge of the lead, so that the first bend does not overlie the lead and the majority of the length of the first portion lies above the lead.

Providing the first bend may further comprise bending the bond wire in a direction opposite to the direction in which the lead lies with respect to the bond wire. The bond wire may further comprise a third portion coupled between the second portion and the die. The method may further comprise: providing at least one further bend between the first end of the bond wire and the first bend, the further bend configured to form at least part of a loop between the first end and the first bend. The bond may be one of a wedge bond and a stitch bond.

The dependent claims provide details of embodiments. The integrated circuit package may further comprise: a further terminal; and a plurality of further bond wires, each further bond wire comprising a first end coupled to the die and a second end coupled to the further lead via a bond; the plurality of further bond wires each further comprising: a first portion between a first bend in the further bond wire and the bond and forming a first angle with respect to the further lead; a second portion forming a second angle with respect to the further lead; wherein the first bend is immediately between the first and second portions and is configured to reduce the angle of the further bond wire with respect to the lead from the second angle to the first angle,
the first bend (252) is in the vicinity of an edge of the lead (202); and the first bend (252) is displaced away from an edge of the lead (202), so that the first bend (252) does not overlie the lead (202); and the majority of the length of the first portion (251) lies above the lead (202).

The respective first ends of the plurality of bond wires may be coupled to a first terminal of the die and the respective first ends of the plurality of further bond wires may be coupled to a second terminal of the die.

### Figures

Embodiments will be described, by way of example only, with reference to the drawings, in which:
Figure 1 is a schematic diagram showing an integrated circuit package;
Figure 2; is a schematic diagram showing an integrated circuit package according to a first embodiment;
Figure 3 is an enlarged view of a portion of figure 2;
Figure 4a, 4b, 4c, 4d and 4e are schematic diagrams, each showing a configuration of a bond wire according to further embodiments; and
Figure 5 is a flow diagram depicting the method steps of some embodiments.

### Description

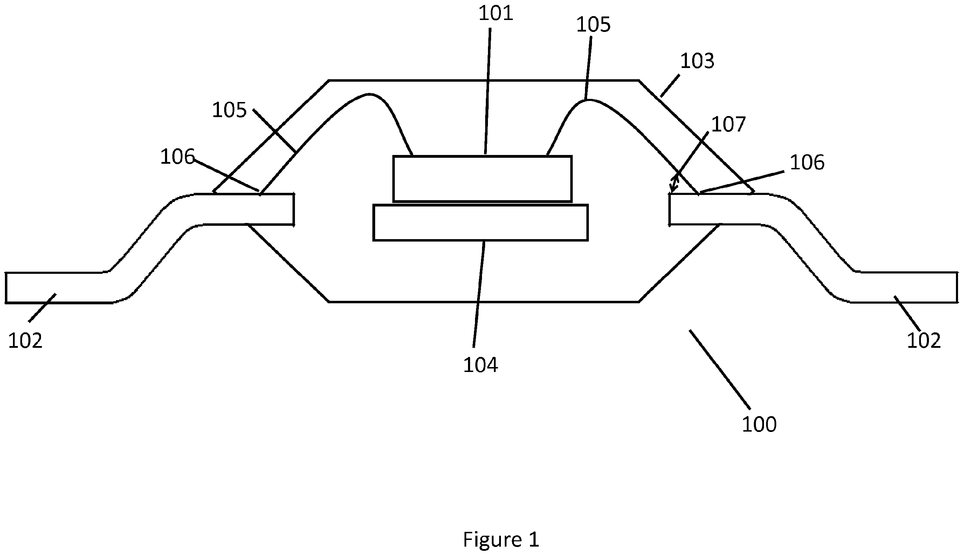

Figure 1 shows an example of an integrated circuit package 100. The integrated circuit package 100 comprises an integrated circuit die 101, and a lead frame comprising leads 102 and a lead frame pad 104 on which the die 101 can be mounted. Bond wires 105 are provided to couple the die 101 to the leads 102. The bone wires 105 may be coupled to the leads 102 using a wedge bond 106. The bond wires 105 may be at an angle 107 with respect to the leads 102 at which a wedge bond is formed. The package may be formed by encapsulating the die 101, lead frame pad 104, bond wires 105 and portion of the leads 102 on which the wedge bond 106 is formed to provide a body 103.

The wedge bonds 106 of the integrated circuit package 101 of figure 1 may be susceptible to wedge bond cracks. In particular these cracks may form when the integrated circuit package is subject to stress, for example mechanical or thermal stress. It will be appreciated that the presence of wedge bond cracks may adversely affect the reliability of the package 100 and may make it unsuitable for some applications.

The present disclosure addresses the formation of wedge bond cracks by adapting the configuration of a bond wire coupled between the die and lead. In particular, the bond wire is configured to comprise a first bend between a first and second portion of the bond wire, which is configured to reduce and angle between the bond wire and the lead for the portion of the bond wire between the first bend and the wedge bond.

The inventors of the present disclosure have recognized that an angle at which the bond wire meets the lead may affect the surface area of the lead contacted by the bond wire. When the bond wire does not entirely contact the surface of the lead, a gap may be left which is subsequently filled by the encapsulating material, for example an epoxy mold compound. In this situation, the wedge bond may be cracked during stress because of the different thermal expansion of the encapsulating material in the gap to the bond wire/wedge bond.

In the present disclosure, the angle at which the bond wire meets the lead is adjusted by introducing a first bend into the bond wire. The bond wire may make contact with an area of the lead preventing a gap in which the encapsulating material may enter.

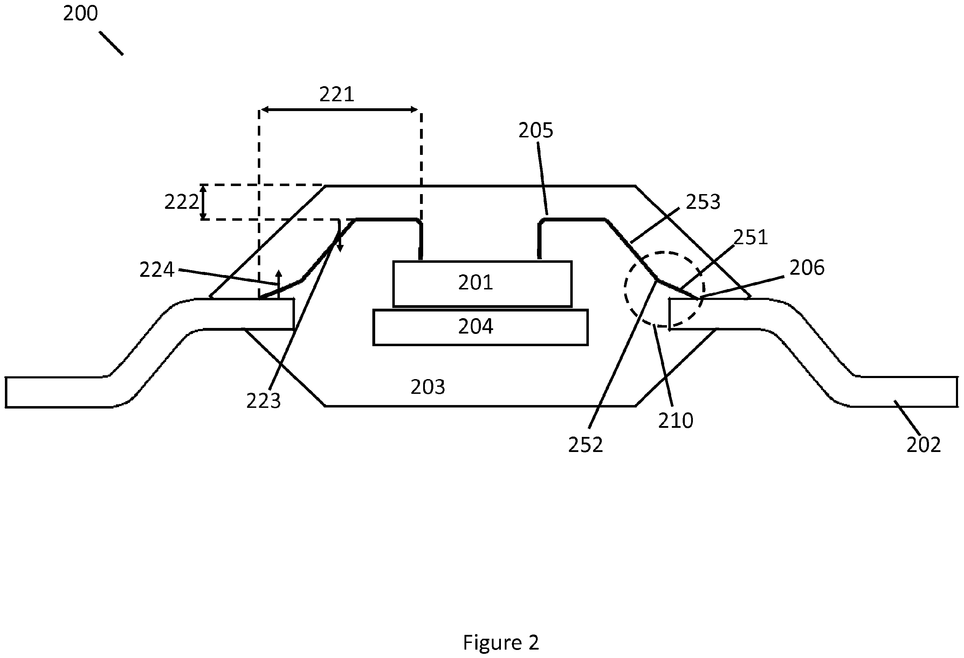

Figure 2 is an example of an integrated circuit package 200 in accordance with some embodiments. The integrated circuit package 200 comprises a die 201 which may be mounted to a lead frame pad 204, a lead 202 and a package body 203. A bond wire 205 is coupled between the die 201 and the lead 202. The bond wire may be coupled to the lead via a wedge bond 206. A first portion 251 of the bond wire may be defined between the wedge bond 206 and a first bend 252 in the bond wire. The first bend 252 may lie immediately between the first portion 251 of the bond wire 205 and a second portion 253 of the bond wire.

It will be appreciated that in figure 2, the configuration of the integrated circuit package 200 is mirrored with the right and left halves of the figure having different labels. It will be appreciated that this is done for clarity only and all reference numerals can equally refer to their mirrored counterpart.

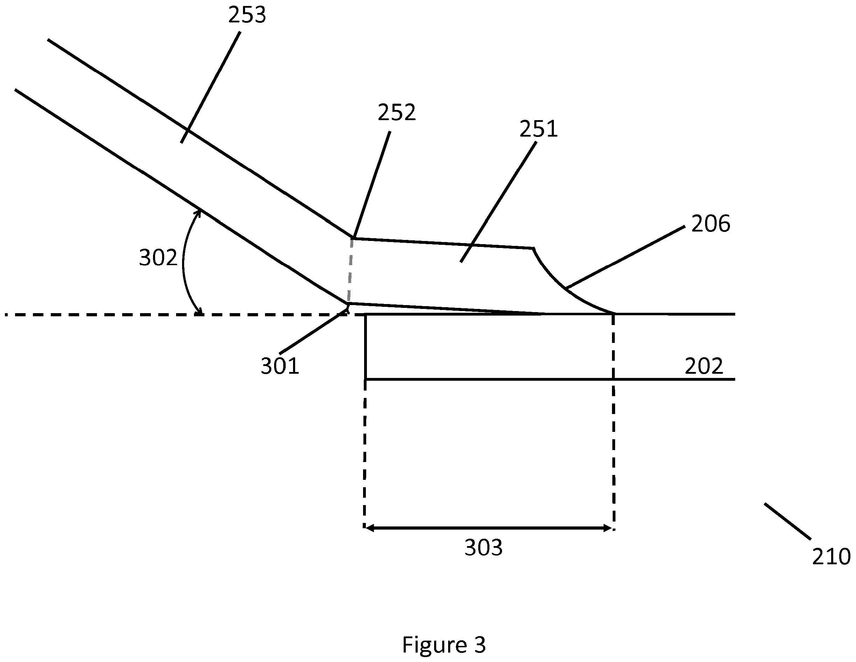

The first portion 251 of the bond wire may be positioned having a first angle with respect to the lead. The second portion may be positioned having a second angle with respect to the lead. The first bend 252 may be provided in the bond wire 205 to reduce the angle between the bond wire 205 and the lead. In this case, the first bend 252 reduces the angle between the bond wire and the lead from the second angle to the first angle. The area of the bond wire and lead indicated by 210 in figure 2 is shown enlarged in figure 3.

Figure 3 shows a portion 210 of the integrated circuit die 200. The portion 210 of the integrated circuit die 200 comprises a portion of the lead 202, the wedge bond 206, the first portion 251 of the bond wire, the second portion 253 of the bond wire and the first bend 252. A first angle 301 between the bond wire at the first portion 251 and the lead is shown. A second angle 302 between the bond wire at the second portion 253 and the lead is shown.

From figure 3, it can be seen that the first bend 252 changes the orientation of the bond wire 205 with respect to the lead in order to reduce the angle between the bond wire 205 and the lead from the second angle 302 to the first angle 301. This angle 302, 301 is reduced with the introduction of the first bend 252. The first bend 252 is provided immediately between the second portion 253 and the first portion 251. The first portion 251 is provided between the wedge bond and the first bend 252. The majority of the length of the first portion 251 is aligned with the lead 202, in other words the majority of the first portion 251 lies above the lead 202. In this manner, the first bend 252 may be in the vicinity of an edge of the lead 202.

In one example, the relationship between the bond wire 205 and the integrated circuit package 200 may be given by a variety of parameters. In this example, a distance 303 between the wedge bond 206 and the edge of the lead is shown in figure 3. Referring back to figure 2, a distance 221 between a point coupling the bond wire to the die and the wedge bond of that bond wire is shown. A distance 222 is additionally shown between the top surface of the integrated circuit package body 203 and a highest point of the bond wire 205 is shown.

It will be appreciated that, in some embodiments, these parameters may have set values, however this will be dependent on the application of the package 200 and thus are by way of example only.

In one example, the parameters may have values according to the following table.

**Table1**

| **Parameter** | **Dimension** |
|---|---|
| 222 - Distance from top of body 203 to closest point of bond wire 205 | More than 0.0125mm |
| 221 - Distance between first end of bond wire coupled to die and second end of bond wire wedge bonded to lead | More than 0.270mm |
| 302 - Second angle Φ | Not over 45 degrees |
| 301 - First angle θ | Not over 10 degrees |
| 303 - Distance between wedge bond and edge of lead | x, where x=y/tanθ and y = the distance between the first portion and the lead |

It will be appreciated that table 1 shows only one example of the values that may be implemented. It will further be appreciated that the first and second angles 301 and 302 may not be dependent on the other parameters. In particular the first and second angles 301 and 302 may take on the values of table 1 without requiring that the other parameters also do so.

Figure 2 further shows a first direction away from the lead 202 depicted by arrow 224 and a second direction towards the lead depicting by arrow 223. It will be appreciated that in order to reduce the angle between the bond wire 205 and the lead 202, the first bend 252 may be provided by bending the bond wire 205 in a direction away from the lead as shown by 224. It will also be appreciated that providing the first bend 252 may provide the first and second portions 251 and 253.

The shape of the bond wire between the coupling point to the die and the first bend 252 (which may include the second portion 253) may be provided in a variety of configurations. Figure 2 shows one example of this configuration however it will be appreciated that other configurations are possible.

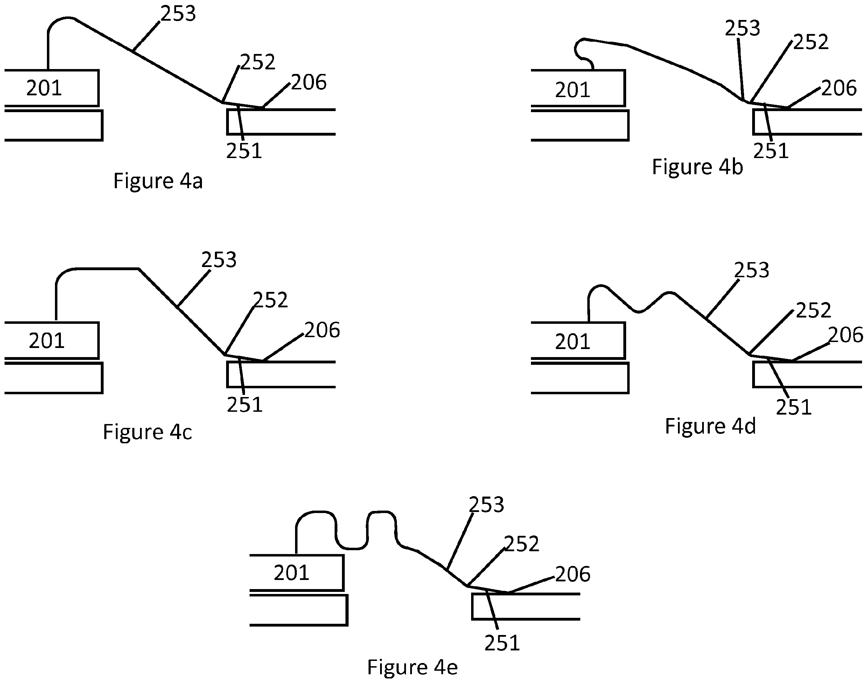

Figures 4a to 4e show various configurations of the portion of the bond wire 205 between the first bend 251 and the die 201. It will be appreciated that in each configuration there is at least one second bend in the bond wire 205. It will be appreciated that these are by way of example only and the configuration of the bond wire 205 between the die 201 and the first bend 251 may take any suitable form. For example, this configuration may be dependent on the application of the die 201, the packaging in which the die 201 is to be implemented and/or the type of tool used to place the bond wire 205.

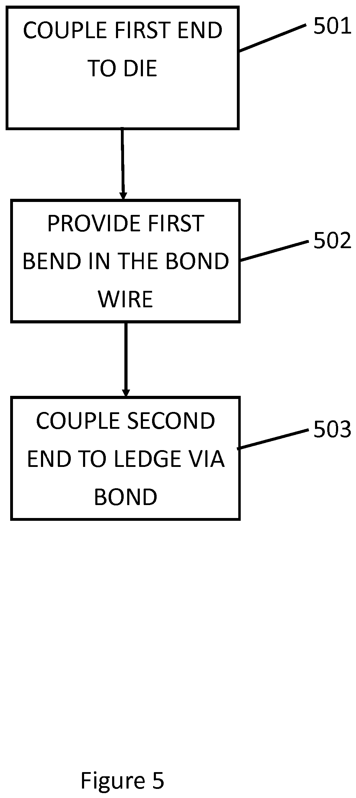

It will appreciated that the configuration of the bond wire 205 may be provided in the manufacture of the integrated circuit die. Figure 5 shows an example of the method steps that may be carried out when coupling a bond wire between an integrated circuit die and lead.

At step 501, a bond wire is coupled to a die. It will be appreciated that the coupling may take place using any suitable means. For example, the bond wire may be wedge bonded to the die using ultrasonic bonding or, alternatively for example be stitch bonded to the die. In some examples, the bond wire may be directly coupled or attached to die, in other examples the bond wire may be coupled to the die via a bonding medium.

At step 502, a first bend may be provided in the bond wire. In some embodiments, the first bend may be provided by the wire bonding tool used to carry out the ultrasonic bonding. The bonding tool may guide the bond wire from the die to the lead and may form a loop shape in the bond wire. Some examples of the loop shape are given in figures 4a to 4e. The first bend may be provided between a first portion of the bond wire and a second portion of the bond wire. The second portion of the bond wire may lie between the first bend and the die. The first portion of the bond wire may lie between the first bend on the wedge bond to the lead.

The first bend may change the angle between the bond wire and the lead from an angle between the second portion of the bond wire and the lead to an angle between the first portion of the bond wire and the lead. The first bend may change the angle by reducing the angle. In some examples, the first bend may be provided by bending the bond wire in a direction opposite to the direction in with the plane in which the lead is provided lies with respect to the bond wire. In other words, the bond wire may be bent away from the bottom or lead frame plane of the package.

After the first bend, the angle between the lead and the first portion of the bond wire may be reduced. In a specific example, the bonding tool may form a loop of bond wire between the die and lead. A second portion of the bond wire (corresponding to the second portion 253) may be formed having an angle of just less than 45 degrees between the second portion and the lead. More generally, the second portion may have an angle of more than 10 degrees, but not more than 45 degrees. The first bend may adjust this angle. For example, the angle between the lead and the first portion of the bond wire between the first bend and the lead may be equal to or less than 10 degrees. The bonding tool may then bond the bond wire to the lead at step 503. It may do so by creating a wedge bond between the first portion of the bond wire and the lead using ultrasonic bonding.

The reduced angle between the first portion of the bond wire and the lead may allow the first portion of the bond wire to contact the surface area of the lead when pressure is applied to it by the bonding tool. This may decrease a gap between the first portion of the bond wire and the lead when compared to a bond wedge of a bond wire having a larger angle between the bond wire and the lead.

In the foregoing a first angle 301 and a second angle 302 have been discussed. It will be appreciated that the second angle may be less than or equal to 90° and the first angle may fall within between 0° and the second angle 302. It will also be appreciated that the bond wire may further comprise at least second bend between the second portion of the bond wire and the first end of the bond wire. This second bend may be configured to orientate the bond wire 205 away from the die and towards the lead.

In the foregoing, the bond between the bond wire 205 and the lead (tail end of the bond wire) is described as being a wedge bond 206 however it will be appreciated that any suitable bond may be used. For example a stitch bond may be used in place of the wedge bond in some examples.

In the foregoing, the bonding of a single bond wire between a die and a lead has been described. It will however be appreciated that an integrated circuit package may comprise a plurality of bond wire and embodiments may be applicable to the plurality of bond wires.

The described embodiments are to be considered in all respects only as illustrative and not restrictive. The scope of the invention is, therefore, indicated by the appended claims rather than by this detailed description.

Reference throughout this specification to features, advantages, or similar language does not imply that all of the features and advantages that may be realized with the present invention should be or are in any single embodiment. Rather, language referring to the features and advantages is understood to mean that a specific feature, advantage, or characteristic described in connection with an embodiment is included in at least one embodiment. Thus, discussions of the features and advantages, and similar language, throughout this specification may, but do not necessarily, refer to the same embodiment.

One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

## Claims

1. An integrated circuit package (100) comprising:
a die (201);
a lead (202); and
a bond wire (205) comprising a first end coupled to the die (201) and a second end coupled to the lead (202) via a bond;
the bond wire (205) further comprising:
a first portion (251) between a first bend (252) in the bond wire (205) and the bond and forming a first angle (301) with respect to the lead (202);
a second portion (253) forming a second angle (302) with respect to the lead (202);
wherein:
the first bend (252) is immediately between the first (251) and second (253) portions, and is configured to reduce the angle of the bond wire (205) with respect to the lead (202) from the second angle (302) to the first angle (301);
**characterized in that**
the first bend (252) is in the vicinity of an edge of the lead (202); and
the first bend (252) is displaced away from an edge of the lead (202), so that the first bend (252) does not overlie the lead (202); and
the majority of the length of the first portion (251) lies above the lead (202).

2. The integrated circuit package (100) of claim 1 wherein the first angle (301) is equal to or less than 10°.

3. The integrated circuit package (100) of any of the preceding claims wherein the bond wire (205) further comprises a third portion coupled between the second portion (253) and the die (201).

4. The integrated circuit package (100) of any of the preceding claims wherein the two or more portions of the bond wire (205) are integral.

5. The integrated circuit package (100) of any of the preceding claims where the bond wire (205) comprises at least one further bend between the first end of the bond wire (205) and the first bend (252), the further bend configured to form at least part of a loop between the first end and the first bend (252).

6. The integrated circuit package (100) of any of the preceding claims wherein the bond is one of a wedge bond and a stitch bond.

7. The integrated circuit package (100) of any of the preceding claims, wherein the first angle (301) is configured to allow the first portion (251) of the bond wire (205) to contact a surface area of the lead (202) when pressure is applied to the lead (202) by a bonding tool, thereby preventing a gap in which encapsulating material might enter during an encapsulating stage.

8. The integrated circuit package (100) of claim 1, comprising:
a plurality of bond wires (205) configured as specified in claim 1.

9. The integrated circuit package (100) of claim 8 further comprising:
a further terminal; and
a plurality of further bond wires (205), each further bond wire (205) comprising a first end coupled to the die (201) and a second end coupled to the further lead (202) via a bond;
the plurality of further bond wires (205) each further comprising:
a first portion between a first bend (252) in the further bond wire (205) and the bond and forming a first angle (301) with respect to the further lead (202);
a second portion (253) forming a second angle (302) with respect to the further lead (202);
wherein:
the first bend (252) is immediately between the first (251) and second (253) portions and is configured to reduce the angle of the further bond wire (205) with respect to the lead (202) from the second angle (302) to the first angle (301);
the first bend (252) is in the vicinity of an edge of the lead (202); and
the first bend (252) is displaced away from an edge of the lead (202), so that the first bend (252) does not overlie the lead (202); and
the majority of the length of
the first portion (251) lies above the lead (202).

10. The integrated circuit package (100) of claim 9, wherein the respective first ends of the plurality of bond wires (205) are coupled to a first terminal of the die (201) and the respective first ends of the plurality of further bond wires (205) are coupled to a second terminal of the die (201).

11. A method for coupling an integrated circuit die (201) to a lead (202) comprising:
coupling (501) a first end of a bond wire (205) to an integrated circuit die (201);
providing (502) a first bend (252) in the bond wire (205) immediately between a first portion (251) of the bond wire (205) and a second portion (253) of the bond wire (205);
coupling (503) a second end of the bond wire (205) to a lead (202) using a bond;
wherein:
the first portion (251) of the bond wire (205) is between the first bend (252) and the bond and forms a first angle (301) with respect to the lead (202);
the first bend (252) is in the vicinity of an edge of the lead (202); and
the first bend (252) is displaced away from an edge of the lead (202) so that the first bend (252) does not overlie the lead (202);
the majority of the length of the first portion (251) lies above the lead (202);
the second portion (253) forms a second angle (302) with respect to the lead (202); and
the first bend (252) is configured to reduce the angle of the bond wire (205) with respect to the lead (202) from the second angle (302) to the first angle (301).

12. The method of claim 11, wherein providing (502) the first bend (252) further comprises bending the bond wire (205) in a direction opposite to the direction in which the lead (202) lies with respect to the bond wire (205).

13. The method of any of claims 11 and 12, wherein the bond wire (205) further comprises a third portion coupled between the second portion (253) and the die (201).

14. The method of any claims 11 to 13, further comprising:
providing at least one further bend between the first end of the bond wire (205) and the first bend (252), the further bend configured to form at least part of a loop between the first end and the first bend (252).

15. The method of any of claims 11 to 14 wherein the bond is one of a wedge bond and a stitch bond.

## Patentansprüche

1. Integrierte Schaltungsbaugruppe (100), die Folgendes umfasst:
einen Chip (201);
eine Leitung (202) und
einen Kontaktierungsdraht (205), der ein erstes Ende, das an den Chip (201) gekoppelt ist, und ein zweites Ende, das mittels einer Kontaktierung an die Leitung (202) gekoppelt ist, umfasst; wobei
der Kontaktierungsdraht (205) ferner Folgendes umfasst:
einen ersten Abschnitt (251), der zwischen einer ersten Biegung (252) im Kontaktierungsdraht (205) und der Kontaktierung liegt und einen ersten Winkel (301) in Bezug auf die Leitung (202) bildet; und
einen zweiten Abschnitt (253), der einen zweiten Winkel (302) in Bezug auf die Leitung (202) bildet; wobei
die erste Biegung (252) unmittelbar zwischen dem ersten (251) und dem zweiten (253) Abschnitt liegt und konfiguriert ist, den Winkel des Kontaktierungsdrahts (205) in Bezug auf die Leitung (202) vom zweiten Winkel (302) zum ersten Winkel (301) zu verringern;
**dadurch gekennzeichnet, dass**
die erste Biegung (252) in der Nähe einer Kante der Leitung (202) liegt;
die erste Biegung (252) von einer Kante der Leitung (202) weg versetzt ist, derart, dass die erste Biegung (252) die Leitung (202) nicht überlagert; und
der Hauptteil der Länge des ersten Abschnitts (251) über der Leitung (202) liegt.

2. Integrierte Schaltungsbaugruppe (100) nach Anspruch 1, wobei der erste Winkel (301) gleich oder kleiner als 10° ist.

3. Integrierte Schaltungsbaugruppe (100) nach einem der vorhergehenden Ansprüche, wobei der Kontaktierungsdraht (205) ferner einen dritten Abschnitt umfasst, der zwischen den zweiten Abschnitt (253) und den Chip (201) gekoppelt ist.

4. Integrierte Schaltungsbaugruppe (100) nach einem der vorhergehenden Ansprüche, wobei die zwei oder mehr Abschnitte des Kontaktierungsdrahts (205) einteilig sind.

5. Integrierte Schaltungsbaugruppe (100) nach einem der vorhergehenden Ansprüche, wobei der Kontaktierungsdraht (205) mindestens eine weitere Biegung zwischen dem ersten Ende des Kontaktierungsdrahts (205) und der ersten Biegung (252) umfasst und die weitere Biegung konfiguriert ist, mindestens einen Teil einer Schleife zwischen dem ersten Ende und der ersten Biegung (252) zu bilden.

6. Integrierte Schaltungsbaugruppe (100) nach einem der vorhergehenden Ansprüche, wobei die Kontaktierung entweder eine Keilkontaktierung oder eine Stichkontaktierung ist.

7. Integrierte Schaltungsbaugruppe (100) nach einem der vorhergehenden Ansprüche, wobei der erste Winkel (301) konfiguriert ist, dem ersten Abschnitt (251) des Kontaktierungsdrahts (205) zu ermöglichen, einen Oberflächenbereich der Leitung (202) zu berühren, wenn durch ein Kontaktierungswerkzeug Druck auf die Leitung (202) aufgebracht wird, wodurch eine Lücke, in die während eines Kapselungsschritts Kapselungsmaterial eintreten könnte, verhindert wird.

8. Integrierte Schaltungsbaugruppe (100) nach Anspruch 1, die Folgendes umfasst:
mehrere Kontaktierungsdrähte (205), die konfiguriert sind, wie in Anspruch 1 festgelegt ist.

9. Integrierte Schaltungsbaugruppe (100) nach Anspruch 8, die ferner Folgendes umfasst:
ein weiteres Endgerät und
mehrere weitere Kontaktierungsdrähte (205), wobei jeder weitere Kontaktierungsdraht (205) ein erstes Ende, das an den Chip (201) gekoppelt ist, und ein zweites Ende, das mittels einer Kontaktierung an die weitere Leitung (202) gekoppelt ist, umfasst; wobei
die mehreren weiteren Kontaktierungsdrähte (205) jeweils ferner Folgendes umfassen:
einen ersten Abschnitt, der zwischen einer ersten Biegung (252) im weiteren Kontaktierungsdraht (205) und der Kontaktierung liegt und einen ersten Winkel (301) in Bezug auf die weitere Leitung (202) bildet; und
einen zweiten Abschnitt (253), der einen zweiten Winkel (302) in Bezug auf die weitere Leitung (202) bildet; wobei
die erste Biegung (252) unmittelbar zwischen dem ersten (251) und dem zweiten (253) Abschnitt liegt und konfiguriert ist, den Winkel des weiteren Kontaktierungsdrahts (205) in Bezug auf die Leitung (202) vom zweiten Winkel (302) zum ersten Winkel (301) zu verringern;
die erste Biegung (252) in der Nähe einer Kante der Leitung (202) liegt;
die erste Biegung (252) von einer Kante der Leitung (202) weg versetzt ist, derart, dass die erste Biegung (252) die Leitung (202) nicht überlagert; und
der Hauptteil der Länge des ersten Abschnitts (251) über der Leitung (202) liegt.

10. Integrierte Schaltungsbaugruppe (100) nach Anspruch 9, wobei die jeweiligen ersten Enden der mehreren Kontaktierungsdrähte (205) an einen ersten Anschluss des Chips (201) gekoppelt sind und die jeweiligen ersten Enden der mehreren weiteren Kontaktierungsdrähte (205) an einen zweiten Anschluss des Chips (201) gekoppelt sind.

11. Verfahren zum Koppeln eines integrierten Schaltungschips (201) an eine Leitung (202), das Folgendes umfasst:
Koppeln (501) eines ersten Endes eines Kontaktierungsdrahts (205) an einen integrierten Schaltungschip (201);
Schaffen (502) einer ersten Biegung (252) im Kontaktierungsdraht (205) unmittelbar zwischen einem ersten Abschnitt (251) des Kontaktierungsdrahts (205) und einem zweiten Abschnitt (253) des Kontaktierungsdrahts (205) und
Koppeln (503) eines zweiten Endes des Kontaktierungsdrahts (205) an eine Leitung (202) unter Verwendung einer Kontaktierung; wobei
der erste Abschnitt (251) des Kontaktierungsdrahts (205) zwischen der ersten Biegung (252) und der Kontaktierung liegt und einen ersten Winkel (301) in Bezug auf die Leitung (202) bildet;
die erste Biegung (252) in der Nähe einer Kante der Leitung (202) liegt;
die erste Biegung (252) von einer Kante der Leitung (202) weg versetzt ist, derart, dass die erste Biegung (252) die Leitung (202) nicht überlagert;
der Hauptteil der Länge des ersten Abschnitts (251) über der Leitung (202) liegt;
der zweite Abschnitt (253) einen zweiten Winkel (302) in Bezug auf die Leitung (202) bildet und
die erste Biegung (252) konfiguriert ist, den Winkel des Kontaktierungsdrahts (205) in Bezug auf die Leitung (202) vom zweiten Winkel (302) zum ersten Winkel (301) zu verringern.

12. Verfahren nach Anspruch 11, wobei das Schaffen (502) der ersten Biegung (252) ferner ein Biegen des Kontaktierungsdrahts (205) in eine Richtung, die der Richtung, in der die Leitung (202) in Bezug auf den Kontaktierungsdraht (205) liegt, entgegengesetzt ist, umfasst.

13. Verfahren nach einem der Ansprüche 11 und 12, wobei der Kontaktierungsdraht (205) ferner einen dritten Abschnitt umfasst, der zwischen den zweiten Abschnitt (253) und den Chip (201) gekoppelt ist.

14. Verfahren nach einem der Ansprüche 11 bis 13, das ferner Folgendes umfasst:
Schaffen mindestens einer weiteren Biegung zwischen dem ersten Ende des Kontaktierungsdrahts (205) und der ersten Biegung (252), wobei die weitere Biegung konfiguriert ist, mindestens einen Teil einer Schleife zwischen dem ersten Ende und der ersten Biegung (252) zu bilden.

15. Verfahren nach einem der Ansprüche 11 bis 14, wobei die Kontaktierung entweder eine Keilkontaktierung oder eine Stichkontaktierung ist.

## Revendications

1. Boîtier (100) de circuit intégré comportant :
une pastille (201) ;
un conducteur (202) ; et
un fil (205) de connexion comportant une première extrémité couplée à la pastille (201) et une deuxième extrémité couplée au conducteur (202) via une soudure ;
le fil (205) de connexion comportant en outre :
une première partie (251) entre un premier coude (252) dans le fil (205) de connexion et la soudure et formant un premier angle (301) par rapport au conducteur (202) ;
une deuxième partie (253) formant un deuxième angle (302) par rapport au conducteur (202) ;
le premier coude (252) se trouvant immédiatement entre les première (251) et deuxième (253) parties, et étant configuré pour réduire l'angle du fil (205) de connexion par rapport au conducteur (202) du deuxième angle (302) au premier angle (301) ;
**caractérisé en ce que** le premier coude (252) se trouve au voisinage d'un bord du conducteur (202) ; et
le premier coude (252) est écarté d'un bord du conducteur (202), de sorte que le premier coude (252) ne recouvre pas le conducteur (202) ; et
la majorité de la longueur de la première partie (251) se situe au-dessus du conducteur (202).

2. Boîtier (100) de circuit intégré selon la revendication 1, le premier angle (301) étant inférieur ou égal à 10°.

3. Boîtier (100) de circuit intégré selon l'une quelconque des revendications précédentes, le fil (205) de connexion comportant en outre une troisième partie couplée entre la deuxième partie (253) et la pastille (201) .

4. Boîtier (100) de circuit intégré selon l'une quelconque des revendications précédentes, lesdites au moins deux parties du fil (205) de connexion étant d'un seul tenant.

5. Boîtier (100) de circuit intégré selon l'une quelconque des revendications précédentes, où le fil (205) de connexion comporte au moins un coude supplémentaire entre la première extrémité du fil (205) de connexion et le premier coude (252), le coude supplémentaire étant configuré pour former au moins une partie d'une boucle entre la première extrémité et le premier coude (252).

6. Boîtier (100) de circuit intégré selon l'une quelconque des revendications précédentes, la soudure étant soit une soudure en biseau, soit une soudure en point de couture.

7. Boîtier (100) de circuit intégré selon l'une quelconque des revendications précédentes, le premier angle (301) étant configuré pour permettre à la première partie (251) du fil (205) de connexion d'entrer en contact avec une zone de surface du conducteur (202) lorsqu'une pression est appliquée au conducteur (202) par un outil de soudure, empêchant ainsi un interstice dans lequel du matériau d'enrobage pourrait entrer au cours d'un stade d'enrobage.

8. Boîtier (100) de circuit intégré selon la revendication 1, comportant :
une pluralité de fils (205) de connexion configurés comme spécifié dans la revendication 1.

9. Boîtier (100) de circuit intégré selon la revendication 8, comportant en outre :
une borne supplémentaire ; et
une pluralité de fils (205) de connexion supplémentaires, chaque fil (205) de connexion supplémentaire comportant une première extrémité couplée à la pastille (201) et une deuxième extrémité couplée au conducteur supplémentaire (202) via une soudure ;
chaque fil de la pluralité de fils (205) de connexion supplémentaires comportant en outre :
une première partie entre un premier coude (252) dans le fil (205) de connexion supplémentaire et la soudure et formant un premier angle (301) par rapport au conducteur supplémentaire (202) ;
une deuxième partie (253) formant un deuxième angle (302) par rapport au conducteur supplémentaire (202) ;
le premier coude (252) se trouvant immédiatement entre les première (251) et deuxième (253) parties et étant configuré pour réduire l'angle du fil (205) de connexion supplémentaire par rapport au conducteur (202) du deuxième angle (302) au premier angle (301) ;
le premier coude (252) se trouvant au voisinage d'un bord du conducteur (202) ; et
le premier coude (252) étant écarté d'un bord du conducteur (202), de sorte que le premier coude (252) ne recouvre pas le conducteur (202) ; et
la majorité de la longueur de la première partie (251) se situant au-dessus du conducteur (202).

10. Boîtier (100) de circuit intégré selon la revendication 9, les premières extrémités respectives de la pluralité de fils (205) de connexion étant couplées à une première borne de la pastille (201) et les premières extrémités respectives de la pluralité de fils (205) de connexion supplémentaires étant couplées à une deuxième borne de la pastille (201).

11. Procédé de couplage d'une pastille (201) de circuit intégré à un conducteur (202), comportant les étapes consistant à :
coupler (501) une première extrémité d'un fil (205) de connexion à une pastille (201) de circuit intégré ;
réaliser (502) un premier coude (252) dans le fil (205) de connexion immédiatement entre une première partie (251) du fil (205) de connexion et une deuxième partie (253) du fil (205) de connexion ;
coupler (503) une deuxième extrémité du fil (205) de connexion à un conducteur (202) à l'aide d'une soudure ;
la première partie (251) du fil (205) de connexion se trouvant entre le premier coude (252) et la soudure et formant un premier angle (301) par rapport au conducteur (202) ; le premier coude (252) se trouvant au voisinage d'un bord du conducteur (202) ; et le premier coude (252) étant écarté d'un bord du conducteur (202), de sorte que le premier coude (252) ne recouvre pas le conducteur (202) ;
la majorité de la longueur de la première partie (251) se situant au-dessus du conducteur (202) ;
la deuxième partie (253) formant un deuxième angle (302) par rapport au conducteur (202) ; et
le premier coude (252) supplémentaire configuré pour réduire l'angle du fil (205) de connexion par rapport au conducteur (202) du deuxième angle (302) au premier angle (301).

12. Procédé selon la revendication 11, la réalisation (502) du premier coude (252) comportant en outre le cintrage du fil (205) de connexion dans une direction opposée à la direction dans laquelle le conducteur (202) se situe par rapport au fil (205) de connexion.

13. Procédé selon l'une quelconque des revendications 11 et 12, le fil (205) de connexion comportant en outre une troisième partie couplée entre la deuxième partie (253) et la pastille (201).

14. Procédé selon l'une quelconque des revendications 11 à 13, comportant en outre :
la réalisation d'au moins un coude supplémentaire entre la première extrémité du fil (205) de connexion et le premier coude (252), le coude supplémentaire étant configuré pour former au moins une partie d'une boucle entre la première extrémité et le premier coude (252).

15. Procédé selon l'une quelconque des revendications 11 à 14, la soudure étant soit une soudure en biseau, soit une soudure en point de couture.
